# EUROPÄISCHE PATENTSCHRIFT

(11) **EP 0 438 627 B1**
(45) Veröffentlichungstag und Bekanntmachung des Hinweises auf die Patenterteilung: **24.05.1995**
(21) Anmeldenummer: 90112124.4
(22) Anmeldetag: 26.06.1990
(51) Int. Cl.: C23C 14/32, C23C 14/06, H01J 37/32

(54) **Bogenentladungsverdampfer mit mehreren Verdampfertiegeln**
Arc-evaporator with several evaporation crucibles
Dispositif d'évaporation par décharge d'arc ayant plusieurs creusets d'évaporation

(30) Priorität: 04.08.1989 DD 331495
(43) Veröffentlichungstag der Anmeldung: 31.07.1991
(73) Patentinhaber: VTD - VAKUUMTECHNIK DRESDEN GMBH, D-01257 Dresden (DE)
(72) Erfinder: Lunow, Thomas, DDR-8045 Dresden (DD); Menzel, Horst, DDR-8028 Dresden (DD); Paetzelt, Peter, DDR-8045 Dresden (DD); Wilberg, Ruediger, Dipl.-Ing., DDR-8019 Dresden (DD); Winkler, Rolf, DDR-8021 Dresden (DD)
(74) Vertreter: Pätzelt, Peter, Dipl.-Ing. Patentanwalt

(56) Entgegenhaltungen:
- DD-A- 232 513
- DD-A- 263 423
- DD-A- 274 747
- DE-A- 3 426 145
- FR-A- 2 614 318

## Beschreibung

Die Erfindung betrifft einen Bogenentladungsverdampfer mit mehreren Verdampfertiegeln, insbesondere zur Herstellung plasmagestützt abgeschiedener Misch- oder Mehrfachschichten. Der Verdampfer kann überall dort vorteilhaft eingesetzt werden, wo zwei oder mehr verdampfbare Stoffe parallel oder nacheinander verdampft werden sollen. Die Abscheidung auf dem Substrat kann für ein oder alle Verdampfungsmaterialien reaktiv erfolgen.

Die Bogenentladungsverdampfer haben besondere Bedeutung bei der plasmagestützten Schichtherstellung erlangt. Dabei ist es unwesentlich, ob eine Glühkathode oder Hohlkathode eingesetzt wird. Mit dem Bogenentladungsverdampfer wird in sehr vorteilhafter Weise die effektive Verdampfung des Verdampfungsmaterials mit der gleichzeitigen Plasmaerzeugung verbunden. Damit werden aufwendige zusätzliche Plasmaerzeugungseinrichtungen vermieden. Verfahrenstypisch liegen die zu beschichtenden Substrate auf negativem Potential gegenüber dem anodischen Verdampfertiegel und das im Plasma teilweise ionisierte Verdampfungsmaterial und/oder Reaktiv- und Trägergas wird mit hoher Energie auf die Substratoberfläche extrahiert. Dieser Mechanismus führt zu hohen Haftfestigkeiten der abgeschiedenen Schicht, hoher Dichte und im Beisen von Reaktivgas zu intensiven Reaktionen der beteiligten Materialien. In großer Breite wurde mittels dieser Technologie die Hartstoffbeschichtung von Verschleißflächen bei Werkzeugen oder Konstruktionsteilen mit TiN, TiC und auch anderen Hartstoffen in die Praxis eingeführt. Darüber hinaus wird die Technologie auch für harte dekorative Beschichtungen vorteilhaft eingesetzt. Speziell das goldfarbene Titannitrid hat dabei breite Anwendung bei der Beschichtung von Armbanduhrengehäusen, Sehhilfen, Schreibgeräten und Schmuckwaren gefunden.

In allen diesen Fällen muß nur ein Metall (Ti, Ta, Hf, Va, Cr, u. a.) verdampft werden, während das zweite Reaktionsmedium als Gas zugeführt wird.

In jüngerer Zeit wird immer häufiger gefordert, mindestens zwei Materialien zu verdampfen. Das ist z. B. erforderlich, wenn auf die TiN-Schicht wegen des "echten" Goldtons noch eine dünne Goldschicht aufgedampft werden soll oder echte Mischschichten, z. B. TiₓAl_{y}, aus festen Materialien hergestellt werden sollen. Nach dem Stand der Technik wird dazu in der Regel jeweils ein zweiter Verdampfer eingesetzt. Die US-PS 4 415 421 gibt eine Einrichtung zur Herstellung einer TiN-Au-Schicht an, bei der das Ti mittels Bogenentladung verdampft wird. Diese Einrichtung erzeugt auch das erforderliche Plasma. Das Gold wird mittels Sputterquelle zerstäubt. Wenn erforderlich, werden weitere Sputterquellen für weitere Materialien, wie Cu oder Pd eingesetzt. Diese Lösung ist durch die einfache Addition von Dampfquellen sehr aufwendig und benötigt einen hohen Anteil an Arbeitsraum.

Bei Mischschichten kann es nachteilig für die Homogenität der Schicht sein, wenn die verschiedenen Dampfströme aus unterschiedlichen Richtungen auf das Substrat gelangen.

Die DD-WP 232 513 beschreibt einen Bogenentladungsverdampfer, bei dem nach anfänglicher Zündung der Entladung zwischen einer Kathode und einem anodischen Tiegel die weitere Entladung zwischen zwei Verdampfertiegeln brennt, die als Elektroden wechselnder Polarität geschaltet sind. Dabei wird auch die Möglichkeit angegeben, in Abhängigkeit eines variierbaren Tastverhältnisses und/oder der Energiemengen aus den beiden Tiegeln unterschiedliche Mengen unterschiedlichen Materials zu verdampfen. Nachteilig bei dieser Einrichtung ist die relativ komplizierte Steuerung. Des weiteren dampft immer auch von dem augenblicklich als Kathode arbeitenden Tiegel Material ab bzw. wird abgesputtert, was dazu führt, daß keine reinen Schichten des auf anodischem Potential liegenden Materials herstellbar sind. Da immer nur einer der beiden Verdampfertiegel als Anode Material verdampft, sind auch keine reinen Mischschichten mittels gleichzeitiger Verdampfung beider Materialien herstellbar.

In der DD-WP 263 423 wird vorgeschlagen, in dem äußeren Plasma eines Bogenentladungsverdampfers einen zusätzlichen anodischen Tiegel anzuordnen und auf diesem Elektronen aus dem Plasma mit solcher Energie und Stromdichte zu extrahieren, daß dort befindliches Verdampfungsmaterial verdampft. Diese Lösung hat sich als relativ gut für die flashartige Verdampfung von geringen Mengen Gold zur Abscheidung auf eine TiN-Schicht bewährt.

Die Lösung ist jedoch auf geringe Verdampfungsmengen von Verdampfungsmaterial mit geringer Verdampfungstemperatur eingeschränkt. Damit ist sie für viele Aufgaben zur Herstellung von Misch- und Mehrfachschichten nicht einsetzbar.

Bei den bekannten hochenergetischen Elektronenstrahlverdampfern sind verschiedene Lösungen für Mehrtiegelverdampfer und mit Springstrahl bekannt. die Übertragung dieser Lösungen auf die Technik der Bogenentladung ist jedoch nicht möglich, da die Hochstrom-Bogenentladung nicht ausreichend gebündelt und gelenkt werden kann.

Die Erfindung verfolgt das Ziel, hochwertige Misch- und Mehrfachschichten plasmagestützt und mit minimalem technischökonomischem Aufwand herzustellen. Der Erfindung liegt die Aufgabe zugrunde, einen Bogenentladungsverdampfer mit mehreren Verdampfertiegeln anzugeben, mit dem die eingesetzten Verdampfungsmaterialien einzeln oder gemeinsam und mit variablem Mischungsverhältnis verdampft werden können.

Erfindungsgemäß wird die Aufgabe durch einen Bogenentladungsverdampfer gelöst, der eine Katode, mehrere anodische Verdampferquellen, die gegeneinander isoliert und jeweils an eine separate Stromquelle angeschlossen sind, sowie ein Magnetsystem aufweist, **dadurch gekennzeichnet**, daß die Verdampferquellen innerhalb einer kompakten Baugruppe mit geringem Abstand zueinander und im wesentlichen in einer Ebene um das Zentrum des Elektronenstroms der Bogenentladung herum angeordnet sind, gegenüber der Katode als Anode geschaltet sind und gemeinsam von einem Magnetsystem umschlossen sind, wobei im Betrieb der Elektronenstrom durch das Magnetfeld auf einen und/oder mehrere Verdampferquellen gelenkt wird.

Wenn beim Betrieb des Verdampfers alle Verdampfertiegel auf gleichem Anodenpotential liegen, dann verteilt sich der Bogenstrom auch relativ gleichmäßig auf alle Tiegel und die Verdampfungsmaterialien werden entsprechend ihrer Verdampfungscharakteristik verdampft. Wenn nur ein Tiegel auf Anodenpotential liegt und die anderen Tiegel auf floatendem Potential, dann brennt die Bogenentladung nur gegen den einen Tiegel mit Anodenpotential und es wird nur dieses Verdampfungsmaterial verdampft. Bei unterschiedlichen Potentialen an den einzelnen Verdampfertiegeln spaltet sich der Elektronenstrom entsprechend auf. Wichtig ist lediglich, daß die einzelnen Verdampfertiegel noch im Wirkbereich des gemeinsamen Magnetsystems zur Bogenlenkung liegen. Unmittelbar über den Tiegeln wird der Bogenstrom dann von den Potentialen beeinflußt. Damit ermöglicht der kompakte Mehrtiegelverdampfer in beliebiger Weise die Verdampfung eines Materials, mehrere Materialien nacheinander und mehrere Materialien in beliebigen Mischungsverhältnissen gleichzeitig. Die Art der Kathode, die für den Verdampfer eingesetzt wird, ist dabei ohne besondere Bedeutung. Glühkathode und Hohlkathode sind beide gut einsetzbar.

Als vorteilhaft hat es sich erwiesen, zwischen den einzelnen Verdampfertiegeln einfache Dampfblenden anzubringen, damit sich die einzelnen Verdampfungsmaterialien nicht bereits im Tiegel beeinflussen und damit die Einzelmaterialien verunreinigt werden. Derartige Dampfblenden dürfen aber nicht den Elektronenstrom von der Kathode zu den anodischen Tiegeln behindern. Je nach Einsatzgebiet des Verdampfers können die Verdampfungstiegel gleichartig oder für die Materialien spezialisiert sein. Z. B. kann ein Verdampfertiegel regulär als Tiegel ausgebildet sein und andere schiffchenartig, auch mit Nachfütterungseinrichtung. Die Nachfütterungseinrichtung muß dabei voll isoliert sein, damit der Bogen nicht gegen diese brennt.

Die Einordnung des Verdampfers in die Verfahrensführung erfolgt in bekannter Weise. So kann die Verdampfung über Mengen- oder Zeitsteuerung erfolgen. Erforderlichenfalls können aber auch in-situ-Steuerungen mit Meßmitteln für jede einzelne Dampfkomponente eingesetzt werden. Erforderlichenfalls können auch reaktive Atmosphären, insbesondere mit N₂, Cₓ oder O₂ eingesetzt werden.

Nachfolgend soll die Erfindung an zwei Beispielen näher erläutert werden.

Die zugehörigen Zeichnungen zeigen in
- Fig. 1: einen Zweitiegelverdampfer gemäß Beispiel I und

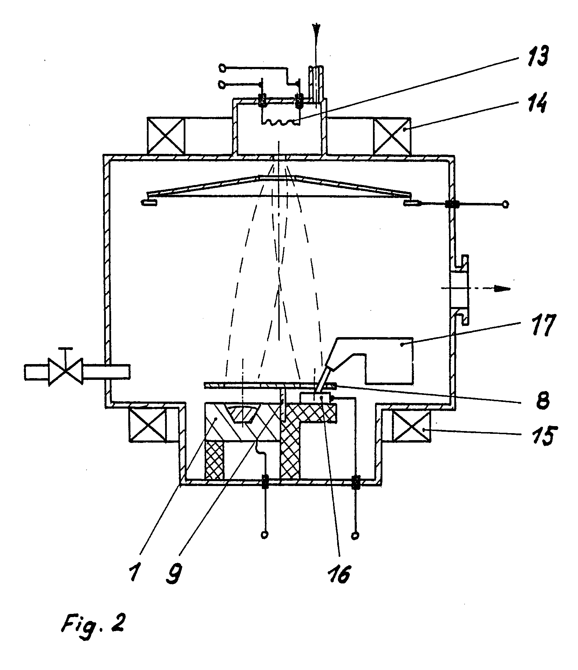

- Fig. 2: einen Verdampfer mit Nachfütterungseinrichtung für ein Material gemäß Beispiel II.

### Beispiel I:

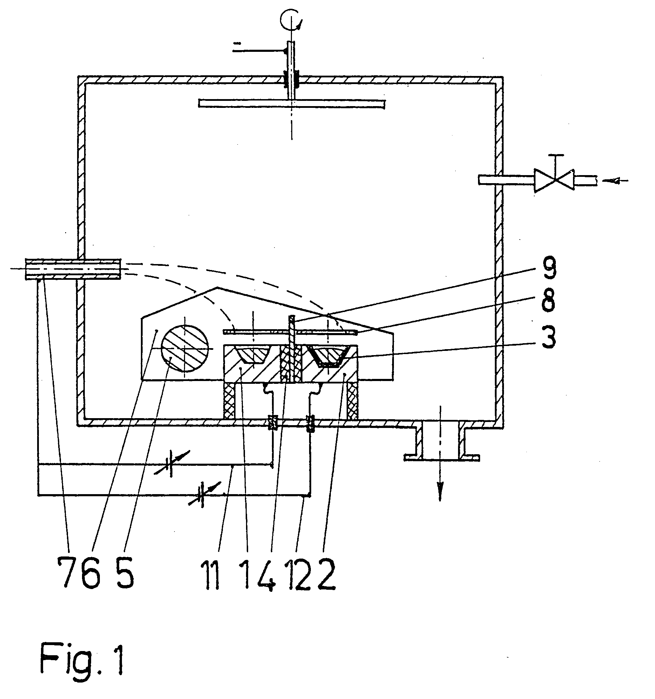

In Beispiel I wird ein Zweitiegelverdampfer beschrieben. Die zugehörige Zeichnung zeigt in Fig. 1 die Kompaktanordnung von einem Verdampfertiegel 1 ohne Auskleidung des Tiegels und einen Verdampfertiegel 2 mit einem Tiegeleinsatz 3 aus Graphit. Beide Verdampfertiegel 1 und 2 sind mittels Keramikisolator 4 gegeneinander isoliert, aber insgesamt als Block montiert. Unmittelbar zugehörig zu dieser Anoden-Baueinheit ist ein gemeinsames Magnetsystem, bestehend aus einer Magnetspule 5 und zwei seitlichen Magnetblechen 6, die über den beiden Verdampfertiegeln 1 und 2 ein longitudinales Magnetfeld erzeugen. Seitlich und baulich getrennt von der Anoden-Baueinheit ist eine Hohlkathode 7 angeordnet. Wenn in bekannter Weise die Bogenentladung gezündet wird, gelangt der Elektronenstrom in den Einflußbereich des Magnetfeldes und wird von diesem auf die Anodentiegel 1 und/oder 2 gelenkt. Als weiteres Mittel zur Führung und Lenkung des Elektronenstroms ist eine gemeinsame Blende 8 isoliert, oberhalb der Verdampfertiegel 1 und 2 angeordnet. Durch ihr floatendes Potential fokussiert die Blende 8 den Elektronenstrom durch die Öffnungen unmittelbar auf das im Verdampfertiegel 1 bzw. 2 liegende Verdampfungsgut. Damit wird insbesondere gesichert, daß der Elektronenstrahl nicht gegen andere Anodenteile als die Tiegel brennt. Unmittelbar zugehörig zu der Blende 8 ist eine vertikale Dampfblende 9 vorgesehen, damit die einzelnen Dampfströme nicht auf den jeweils anderen Tiegel gelangen können und dort zu unerwünschten Ablagerungen führen.

Die Potentialzuführung zu den anodischen Verdampfertiegeln 1 und 2 erfolgt getrennt über die Zuführungen 11 und 12. Auf die Darstellung der Kühlwasserzuführung wurde wegen der Übersichtlichkeit verzichtet. Nachfolgend wird der Einsatz dieses Verdampfers zur Herstellung einer Ti-Cu-Mischschicht im Verhältnis von 5 : 1 beschrieben, wie sie für abriebfeste elektrische Kontaktflächen eingesetzt werden kann.

In bekannter Weise wird im Rezipienten ein Argondruck von < 1 x 10⁻³ Pa eingeregelt. Danach wird die Bogenentladung in der Hohlkathode 7 gezündet, wobei der Verdampfertiegel 1 mit dem Verdampfungsmaterial Titan als Anode dient. Nach einer kurzzeitigen Stabilisierung der Entladung wird der Anodenstrom am Verdampfertiegel 2 auf 50 A eingeregelt. Damit werden als Verdampfungsraten für Ti von 0,5 g/min und für Cu von 0,1 g/min erzielt. Die abgeschiedene Ti-Cu-Schicht ist entsprechend der plasmagestützten Abscheidung haftfest, dicht, weist eine gute Leitfähigkeit auf und ist in sich sehr homogen. Die Herstellung mit dem erfindungsgemäßen Mehrtiegelverdampfer ist sehr kostengünstig und gut regelbar.

Durch Änderung der Anodenströme an den Verdampfertiegeln kann das Mischungsverhältnis der Schicht praktisch von 100:0 bis 0:100 variiert werden. Unter Beteiligung von Reaktivgasen insgesamt oder zeitweise kann die Variabilität der herstellbaren Schichttypen noch wesentlich erhöht werden.

### Beispiel II:

Nachfolgend wird ein erfindungsgemäßer Verdampfer beschrieben, bei dem ein Verdampfungsmaterial ständig nachgefüttert wird. Dieser Verdampfer ist besonders für Aluminium-Mischschichten geeignet, da Al mittels der bekannten Bogenentladung relativ schwer verdampft werden kann.

Bei diesem Verdampfer ist als Kathode eine Glühkathode 13 eingesetzt. Das gemeinsame Magnetsystem besteht aus den Magnetspulen 14 und 15 und die beiden Verdampferquellen sind einmal, wie in Fig. 1, der Verdampfertiegel 1 für die Verdampfung von Ti aus dem Tiegel und unmittelbar mit diesem als Baueinheit kombiniert ein Verdampferschiffchen 16 aus Titanborid für die Verdampfung von Al. Das Al wird über eine Nachfütterungseinrichtung 17 dem Verdampfer zugeführt. Als Beispiel soll mit diesem Verdampfer eine TiₓAl_{y}N_{z}-Schicht als Verschleißschutzschicht für ein Schneidwerkzeug hergestellt werden. Das Verfahren wird wie im Beispiel I gestartet. Danach wird am Verdampfertiegel 1 ein Anodenstrom von 350 A eingeregelt und am Verdampferschiffchen 16 ein Anodenstrom von 40 A. Die Verdampfungsraten liegen dabei für Ti bei 0,5 g/min und für Al bei 0,2 g/min. Das Verhältnis der beiden Verdampfungsraten zueinander kann in diesem Fall über die jeweiligen Anodenströme geregelt werden, aber auch in bestimmten Grenzen über die Drahtvorschubgeschwindigkeit des Al-Drahtes. Der Stickstoffpartialdruck wird auf 1 x 10⁻¹ Pa eingeregelt.

Wenn es technologisch vorteilhaft ist, kann das Mischungsverhältnis auch variiert werden, z. B. daß unmittelbar auf dem Substrat erst eine reine Ti-Schicht abgeschieden wird, danach mit einem Gradienten eine TiN-Schicht und erst darauf wieder mit Gradienten eine TiₓAl_{y}N_{z}-Schicht.

In beiden Ausführungsbeispielen ist deutlich die Vielfalt der möglichen Einsatzfälle der Verdampfer erkennbar, mit dem Vorteil, daß nur ein relativ geringer technisch-ökonomisch und räumlicher Aufwand erforderlich ist.

In den zwei Beispielen wurden jeweils zwei Verdampfertiegel bzw. -schiffchen eingesetzt. Es ist jedoch einleuchtend, daß auch drei oder vier Tiegel möglich sind, jedoch steht hierbei die Frage, ob der praktische Bedarf vorhanden ist, daß in einem Verfahrenzyklus derart viel Materialien verdampft werden müssen.

## Patentansprüche

1. Bogenentladungsverdampfer, insbesondere zur Herstellung von Misch- und Mehrfachschichten, der eine Katode, mehrere anodische Verdampferquellen, die gegeneinander isoliert und jeweils an eine separate Stromquelle angeschlossen sind, sowie ein Magnetsystem aufweist, **dadurch gekennzeichnet,** daß die Verdampferquellen (1, 2, 16) innerhalb einer kompakten Baugruppe mit geringem Abstand zueinander und im wesentlichen in einer Ebene um das Zentrum des Elektronenstroms der Bogenentladung herum angeordnet sind, gegenüber der Katode als Anode geschaltet sind und gemeinsam von einem Magnetsystem (5, 6) umschlossen sind wobei im Betrieb der Elektronenstrom durch das Magnetfeld auf eine und/oder mehrere Verdampferquellen gelenkt wird.

2. Bogenentladungsverdampfer nach Anspruch 1, **dadurch gekennzeichnet**, daß zwischen den einzelnen Verdampferquellen Dampfblenden (9) vorhanden sind.

3. Bogenentladungsverdampfer nach Anspruch 1, **dadurch gekennzeichnet**, daß oberhalb mindestens einer Verdampferquelle eine Blende (8) isoliert angeordnet ist.

4. Bogenentladungsverdampfer nach Anspruch 1, **dadurch gekennzeichnet**, daß einem oder mehreren Verdampfertiegeln (1, 2, 16) isolierte Nachschubeinrichtungen (17) zugeordnet sind.

## Claims

1. Arc discharge evaporator, in particular for producing a mixture of layers and multi-layers, which comprises a cathode, a plurality of anodic evaporation sources, which are isolated with respect to each other and are connected in each case to a separate source of current, as well as a magnet system, characterised in that the evaporation sources (1, 2, 16) are disposed within a compact subassembly at a spaced disposition with respect to each other and substantially in one plane about the centre of the electron current of the arc discharge, are connected opposite the cathode as an anode and are encompassed in common by a magnet system (5, 6), wherein during operation the electron current is directed by virtue of the magnetic field to one and/or a plurality of evaporation sources.

2. Arc discharge evaporator according to claim 1, characterised in that vapour screens (9) are provided between the individual evaporation sources.

3. Arc discharge evaporator according to claim 1, characterised in that a screen (8) is disposed in an isolated manner above at least one evaporation source.

4. Arc discharge evaporator according to claim 1, characterised in that isolated feeding devices (17) are associated with one or a plurality of evaporation crucibles (1, 2, 16).

## Revendications

1. Vaporisateur à décharge par arc, notamment pour la fabrication de couches mélangées ou multiples, comprenant une cathode, plusieurs sources de vaporisation anodiques, isolées les unes des autres et reliées chacune à une source de courant distincte ainsi qu'à un système magnétique, caractérisé en ce que les sources de vaporisation (1, 2, 16) sont regroupées de manière compacte, très peu écartées les unes des autres et se trouvent essentiellement placées dans un plan autour du centre du courant électronique de l'arc de décharge, en étant branchées comme anodes en regard de la cathode, et entourées en commun par un système magnétique (5, 6), le courant électronique étant dévié par le champ magnétique vers l'une ou plusieurs sources de vaporisation.

2. Vaporisateur selon la revendication 1, caractérisé par des écrans de vapeur (9) placés entre les différentes sources de vaporisation.

3. Vaporisateur selon la revendisation 1, caractérisé par un écran (8) isolé disposé au moins au-dessus d'une source de vaporisation.

4. Vaporisateur selon la revendication 1, caractérisé en ce qu'un mécanisme d'avance (17), isolé, est associé à un ou plusieurs creusets de vaporisation.
